# EUROPÄISCHE PATENTSCHRIFT

(11) **EP 1 460 477 B1**
(45) Veröffentlichungstag und Bekanntmachung des Hinweises auf die Patenterteilung: **26.03.2008**
(21) Anmeldenummer: 04012520.5
(22) Anmeldetag: 18.07.2002
(51) Int. Cl.: G03F 1/00, G03F 7/004

(54) **Verfahren zur Herstellung von Zeitungsflexodruckplatten**
Process for fabricating newspaper flexographic printing plates
Procédé pour la fabrication d'une plaque d'impression flexographique pour des journaux

(30) Priorität: 03.08.2001 DE 10137629
(43) Veröffentlichungstag der Anmeldung: 22.09.2004
(62) Teilanmeldung aus: 02794506.2
(73) Patentinhaber: Flint Group Germany GmbH, 70469 Stuttgart (DE)
(72) Erfinder: Knöll, Rolf, Dr., 69514 Laudenbach (DE); Sandig, Hartmut, Dr., 67227 Frankenthal (DE); Stebani, Uwe, Dr., 67592 Flörsheim-Dalsheim (DE); Telser, Thomas, Dr., 69120 Heidelberg (DE); Zwez, Thomas, Dr., 76199 Karlsruhe (DE)
(74) Vertreter: Isenbruck, Günter

(56) Entgegenhaltungen:
- EP-A- 0 422 488
- EP-A- 0 767 407
- EP-A- 1 158 364
- WO-A-96/16356
- JP-A- 58 052 646
- US-A- 4 045 231
- US-A- 5 262 275
- US-A- 5 506 086
- US-A- 5 607 814

## Beschreibung

Die vorliegende Erfindung betrifft ein Verfahren zur Herstellung von Zeitungsflexodruckplatten, bei dem man als Ausgangsmaterial ein digital bebilderbares, fotoempfindliches Flexodruckelement umfassend mindestens einen flexiblen, metallischen Träger, eine darauf aufgebrachte Haftschicht, eine organisch entwickelbare fotopolymerisierbare Schicht, eine digital bebilderbare Schicht sowie optional eine abziehbare Schutzfolie, wobei die Gesamtdicke des Flexodruckelementes 300 bis 1000 µm beträgt, das elastomere Bindemittel ein Gewichtsmittel M_{w} von 80 000 bis 150 000 g/mol, einen Styrol-Gehalt von 20 - 50 Gew.-% bezüglich des Bindemittels und eine Härte Shore A von 50 bis 80 aufweist, und die Menge an Weichmacher 10 bis 40 Gew. %, bezogen auf die Menge aller Bestandteile der fotopolymerisierbaren Schicht, beträgt, einsetzt, wobei man eine Maske in die digital bebilderbare Schicht einschreibt, bildmäßig mit aktinischem Licht belichtet, die belichtete Schicht mit einem organischen Lösemittel oder einem organischen Lösemittelgemisch entwickelt und gleichzeitig die digital bebilderbare Schicht bzw. dessen Reste entfernt und das Element bei 105 bis 160°C trocknet.

Tageszeitungen werden heutzutage noch meistens nach dem Offset-Druckverfahren hergestellt. Zunehmend wird jedoch auch Flexodruck zum Drucken von Tageszeitungen eingesetzt, weil Flexodruck eine Reihe von technischen Vorteilen aufweist. Beim Flexodruckverfahren kann der Druck viel schneller angefahren werden als beim Offset-Verfahren. Neben der Zeitersparnis bedeutet dies auch eine erhebliche Papierersparnis. Weiterhin wird beim Offsetdruck mit pastösen, mineralölhaltigen Farben gedruckt. Beim Coldset-Offsetdruck verbleiben die Öle zum großen Teil im Papier, was erheblich Mengen an schwarzem Abrieb hervorruft. Bei Heatset-Offsetdruck werden die Mineralöle beim Trocknen der Druckfarbe freigesetzt. Beim Flexodruck mit Druckfarben auf Wasserbasis, die schnell ins Papier wegschlagen, ist der schwarze Abrieb deutlich reduziert und es werden keine Lösemittel emittiert. Die Druckmaschinen können auf einfache Art und Weise mit Wasser gereinigt werden.

Nachteilig am Flexodruck im Vergleich zum Offsetdruck ist jedoch, dass die Verarbeitungszeit vom fotoempfindlichen Flexodruckelement bis zum fertigen Flexodruckklischee erheblich länger ist als die Verarbeitungszeit bei Offsetdruckplatten. Typische Verarbeitungszeiten für Flexodruckplatten liegen in der Größenordnung von 6 h und mehr. Für den Druck von Tageszeitungen mit Flexodruckplatten sind jedoch Verarbeitungszeiten von mehr als 30 min kaum noch akzeptabel. Es besteht daher ein Bedarf nach geeigneten Verfahren zur Verkürzung der Verarbeitungszeit.

Es ist im Stand der Technik bekannt, Flexodruckformen für den Zeitungsdruck ausgehend von wässrig entwickelbaren Flexodruckelementen herzustellen. EP-A 371 123 offenbart ein Verfahren und eine Apparatur zum Herstellen von Flexodruckplatten für den Zeitungsdruck, bei dem das Auswaschen mit Wasser mit einem Druck von 35 bis 70 bar erfolgt, welches mittels einer Düse auf das Flexodruckelement gespritzt wird. Die Auswaschgeschwindigkeit kann durch Erhöhung des Drucks zwar gesteigert werden, aber dadurch können feine Reliefelemente beschädigt werden. Wässrig entwickelbare Flexodruckplatten weisen weiterhin den Nachteil auf, dass sie gegenüber Druckfarben häufig eine unzureichende Quellstabilität aufweisen. Dies gilt sowohl für Flexodruckfarben auf Wasserbasis wie für solche mit organischen Lösungsmitteln wie Alkoholen oder Estern.

Weiterhin ist die Auflösung wässrig entwickelbarer Platten für manche Anwendungen unzureichend. Es ist bekannt, dass man mit organisch entwickelbaren Flexodruckplatten auch Auflösungen von 60 L/cm erreichen kann. Es wäre daher wünschenswert, auch Platten auf Basis organischer Bindemittel zum Zeitungsdruck einsetzen zu können.

Der Fachmann sieht sich beim Zeitungsflexodruck aber noch weiteren Problemen gegenüber. Bei Zeitungspapier handelt es sich um einen vergleichsweise rauen Bedruckstoff. Zum Drucken auf rauen Bedruckstoffen sind besonders weiche Flexodruckplatten, beispielsweise solche mit einer Shore A-Härte zwischen 30 und 40, geeignet, die sich einer unebenen oder rauen Oberfläche des Bedruckstoffes besser anpassen können. Dies ist beispielsweise dargestellt in "Technik des Flexodrucks", S. 141/142, 4. Aufl., 1999, Coating Verlag, St. Gallen, Schweiz. Je weicher jedoch ein druckendes Relief, umso stärker treten an den Rändern der einzelnen Reliefelemente beim Drucken sogenannte "Quetschränder" auf, die zu einem unsauberen Druckbild führen und die Auflösung limitieren. Dies gilt insbesondere für sehr kleine Reliefelemente wie bspw. feine Rastertonwerte, dünne Linien oder kleine Schriften, weil diese dem Anpressdruck des Druckzylinders aufgrund ihrer kleinen Fläche nur einen geringen Widerstand entgegensetzen können. Gerade derartige Reliefelemente sind aber beim Zeitungsdruck wichtig.

EP-A 0 422 488 betrifft photopolymerisierbare Gemische aus elastomeren Blockcopolymerisaten als Bindemitteln, damit verträglichen photopolymerisierbaren niedermolekularen Verbindungen, Photoinitiatoren sowie gegebenenfalls weiteren Zusatz- und Hilfsstoffen, die als Bindemittel elastomere Vinylaromat/Dien-Blockcopolymerisate mit kationisierten Diamin-Endgruppen enthalten, sowie lichtempfindliche Aufzeichnungselemente für die Herstellung von Flexodruckformen mit einer Aufzeichnungsschicht aus diesen photopolymerisierbaren Gemischen.

US 4,045,231 betrifft photoempfindliche Zusammensetzungen für flexographische Druckplatten enthaltend (a) ein Styrol-Butadien-Blockcopolymer mit 35 bis 50 Gew.-% Styrol, (b) mindestens ein flüssiges Präpolymer miteinem Molekulargewicht von 1000 bis 5000, ausgewählt aus Polybutadien und Butadien-Styrol-Copolymer, und (c) mindestens ein photopolymerisierbares Monomer.

US 5,506,086, US 5,262, 275, US 5,607,814 und WO 96/16356 betreffen photosensitive Druckelemente umfassend einen IR-transparenten Träger, eine IR-transparente photopolymerisierbare Schicht und eine IR-sensitive, selbst-ablative Schicht. Die IR-sensitive, selbst-ablative Schicht kann Weichmacher enthalten. Der Trocknungsschritt nach der Entwicklung der photopolymerisierten Schicht wird bei einer Temperatur von 60°C durchgeführt.

Aufgabe der vorliegenden Erfindung war es daher, ein schnelleres Verfahren zur Herstellung von Flexodruckplatten für den Zeitungsdruck bereitzustellen, mit welchem die Verarbeitungszeiten deutlich verkürzt werden können. Aufgabe der Erfindung war es weiterhin, fotoempfindliche Flexodruckelemente bereitzustellen, die einerseits eine schnelle Verarbeitung zu Flexodruckformen ermöglichen und weiterhin den Druck auf rauem Zeitungspapier in hoher Auflösung ermöglichen.

Demgemäß wurde ein Verfahren zur Herstellung von Zeitungsflexodruckplatten gefunden, bei dem man als Ausgangsmaterial ein digital bebilderbares, fotoempfindliches Flexodruckelement, welches mindestens einen flexiblen, metallischen Träger, eine darauf aufgebrachte Haftschicht, eine organisch entwickelbare fotopolymerisierbare Schicht, eine digital bebilderbare Schicht sowie optional eine abziehbare Schutzfolie umfasst, wobei die Gesamtdicke des Flexodruckelementes 300 bis 1000 µm beträgt, das elastomere Bindemittel ein Gewichtsmittel M_{w} von 80 000 bis 150 000 g/mol, einen Styrol-Gehalt von 20 - 50 Gew.-% bezüglich des Bindemittels und eine Härte Shore A von 50 bis 80 aufweist und die Menge an Weichmacher 10 bis 40 Gew. %, bezogen auf die Menge aller Bestandteile der fotopolymerisierbaren Schicht, beträgt, einsetzt, eine Maske in die digital bebilderbare Schicht einschreibt, mit aktinischem Licht belichtet, die belichtete Schicht mit einem organischen Lösemittel oder einem organischen Lösemittelgemisch entwickelt und gleichzeitig die digital bebilderbare Schicht bzw. deren Reste entfernt und das Element bei 105 bis 160°C trocknet

Überraschend und auch für den Fachmann unerwartet war es, dass die Aufgabe der Erfindung nicht durch eine Flexodruckform mit einer weichen Reliefschicht gelöst wird, sondern im Gegenteil von einer Flexodruckform mit einer relativ harten Reliefschicht. Durch die erfindungsgemäße Kombination eines relativ harten elastomeren Bindemittels mit hohen Weichmachermengen konnte eine überraschend deutliche Verkürzung der Verarbeitungszeiten erzielt werden. Das erfindungsgemäß eingesetzte Flexodruckelement lässt sich mittels des erfindungsgemäßen Verfahrens innerhalb weniger als 30 min zu einer druckfertigen Flexodruckform verarbeiten.

Zu der Erfindung ist im Einzelnen das Folgende auszuführen.

Das erfindungsgemäß eingesetzte fotoempfindliche Flexodruckelement weist einen flexiblen metallischen Träger auf. Unter flexibel im Sinne dieser Erfindung soll verstanden werden, dass die Träger so dünn sind, dass sie um Druckzylinder gebogen werden können. Sie sind andererseits aber auch dimensionsstabil und so dick, dass der Träger bei der Produktion des Flexodruckelementes oder der Montage der fertigen Druckplatte auf den Druckzylinder nicht geknickt wird.

Als flexible metallische Träger kommen vor allem dünne Bleche oder Metallfolien aus Stahl, bevorzugt aus rostfreiem Stahl, magnetisierbarem Federstahl, Aluminium, Zink, Magnesium, Nickel, Chrom oder Kupfer in Betracht, wobei die Metalle auch noch legiert sein können. Es können auch kombinierte metallische Träger wie beispielsweise mit Zinn, Zink, Chrom, Aluminium, Nickel oder auch Kombinationen verschiedener Metalle beschichtete Stahlbleche eingesetzt werden, oder auch solche Metallträger, die durch Laminieren gleich- oder verschiedenartiger Metallbleche erhalten werden. Weiterhin können auch vorbehandelte Bleche, wie beispielsweise phosphatierte oder chromatisierte Stahlbleche oder eloxierte Aluminiumbleche eingesetzt werden. Im Regelfalle werden die Bleche oder Folien vor dem Einsetzen entfettet. Bevorzugt eingesetzt werden Träger aus Stahl oder Aluminium, besonders bevorzugt ist magnetisierbarer Federstahl.

Die Dicke derartiger flexibler metallischer Träger beträgt üblicherweise zwischen 0,025 mm und 0,4 mm und richtet sich neben dem gewünschten Grad an Flexibilität auch nach der Art des eingesetzten Metalls. Träger aus Stahl haben üblicherweise eine Dicke zwischen 0,025 und 0,25 mm, insbesondere zwischen 0,14 und 0,24 mm. Träger aus Aluminium haben üblicherweise eine Dicke zwischen 0,25 und 0,4 mm.

Der flexible metallische Träger weist eine sich darauf befindliche Haftschicht auf. Die Haftschicht vermittelt eine gute Haftung zwischen dem flexiblen, metallischen Träger und der später aufzubringenden fotopolymerisierbaren Schicht, so dass die durch bildmäßiges Belichten der fotopolymerisierbaren Schicht erhaltenen druckenden Elemente weder beim Entwickeln der Platte noch beim Drucken abreißen, abgelöst werden oder abknicken. Im Prinzip können beliebige Haftschichten eingesetzt werden, vorausgesetzt, sie vermitteln ausreichende Haftung.

In einer bevorzugten Ausführungsform umfasst die Haftschicht vorteilhaft einen UV-Absorber. Der UV-Absorber vermeidet, dass UV-Licht vom metallischen Träger zurück in die Reliefschicht gestreut wird. Derartige Reflektionen können u.U. den Belichtungsspielraum verringern und die mögliche Auflösung verschlechtern. Zur Ausführung der Erfindung besonders geeignete Haftschichten sind beispielsweise in der Anmeldung DE-A 100 40 929 offenbart.

Das erfindungsgemäß eingesetzte Flexodruckelement umfasst weiterhin eine organisch entwickelbare, fotopolymerisierbare Schicht, welche ihrerseits mindestens ein elastomeres Bindemittel, ethylenisch ungesättigte Monomere, einen Fotoinitiator oder ein Fotoinitiatorsystem, mindestens einen Weichmacher sowie optional weitere Bestandteile umfasst.

Erfindungsgemäß weist das elastomere Bindemittel ein mittleres Molekulargewicht M_{w} (Gewichtsmittel) von 80 000 bis 150 000 g/mol auf. Ist das Molekulargewicht größer, ist die Verarbeitungszeit nicht mehr in jedem Falle ausreichend, obwohl auch noch bei höherem Molekulargewicht in Spezialfällen zufriedenstellende Ergebnisse erreicht werden können. Ist das Molekulargewicht kleiner, so ist die Härte der Schicht nicht mehr in jedem Falle ausreichend, obwohl auch noch bei geringerem Molekulargewicht in Spezialfällen zufriedenstellende Ergebnisse erzielt werden können. Bevorzugt beträgt das Molekulargewicht 90 000 bis 140 000 g/mol und besonders bevorzugt 100 000 bis 130 000 g/mol.

Erfindungswesentlich ist weiterhin die Shore A-Härte des eingesetzten elastomeren Bindemittels. Diese wird nach der Vorschrift von ISO 868 bestimmt. Erfindungsgemäß weist das eingesetzte elastomere Bindemittel eine Härte von 50 bis 80 Shore A auf. Bevorzugt beträgt die Härte des Bindemittels 55 bis 75 Shore A und ganz besonders bevorzugt 60 bis 75 Shore A.

Bei geeigneten elastomeren Bindemitteln kann es sich sowohl um elastomere wie um thermoplastisch elastomere Bindemittel handeln. Beispiele sind die bekannten Blockcopolymere vom SIS- oder SBS-Typ, die auch ganz oder teilweise hydriert sein können. Weitere Beispiel umfassen elastomere Polymere vom Ethylen/Propylen/Dien-Typ oder elastomere Polymere auf Basis von Acrylaten bzw. Acrylat-Copolymeren. Der Fachmann trifft unter den prinzipiell geeigneten Elastomeren eine geeignete Auswahl unter Beachtung der erfindungswesentlichen Parameter von Härte und Molekulargewicht. Im Regelfalle ist das elastomere Bindemittel selbst in organischen Lösemitteln löslich oder zumindest darin quellbar. Bevorzugt ist das Bindemittel löslich. Es ist für die Erfindung jedoch ausreichend, dass die Schicht als Ganzes organisch entwickelbar ist.

Als elastomere Bindemittel eignen sich insbesondere thermoplastisch elastomere Blockcopolymere vom SIS- oder SBS-Typ. Dabei kann es sich um lineare Dreiblockcopolymere, Zweiblockcopolymere, um Polymere mit mehreren elastomeren und thermoplastischen Blöcken, um radiale oder quasi-radiale Blockcopolymere, sowie um Gemische davon handeln. Geeignet sind weiterhin auch Blockcopolymere vom Typ S-(SB)-S, deren elastomere Blöcke statistisch aus Butadien und Styrol zusammengesetzt sind. Derartige Polymere sind unter dem Namen Styroflex^{®} bekannt.

Bevorzugt werden SBS-Blockcopolymere eingesetzt. Der Styrolgehalt geeigneter SBS-Blockcopolymere beträgt üblicherweise 20 bis 50 Gew. %, bevorzugt 25 bis 45 Gew. % und besonders bevorzugt 25 bis 40 Gew. %. Geeignete SBS-Polymere sind beispielsweise unter dem Namen Kraton^{®} erhältlich.

Die fotopolymerisierbare Schicht kann neben den genannten Bindemitteln auch noch mindestens ein sekundäres Bindemittel in kleinen Mengen enthalten. Diese dienen zur Feinsteuerung der Eigenschaften der Schicht und müssen nicht unbedingt die geschilderten Anforderungen im Hinblick auf Shore A Härte und M_{w} erfüllen, solange die Eigenschaften der Druckform zum Zeitungsdruck nicht negativ beeinflusst werden. Im Regelfalle beträgt die Menge eines sekundären Bindemittels 0 bis 10 Gew.-% bezogen auf alle Bestandteile der Schicht.

Besonders bevorzugt handelt es sich bei dem sekundären Bindemittel um 1 bis 10 Gew. %, bezogen auf die Menge aller Bestandteile der fotopolymerisierbaren Schicht, eines SIS-Blockcopolymeren. Geeignete SIS-Polymere sind zum Beispiel unter dem Namen Kraton^{®} zu erhalten.

Die Menge an elastomerem Bindemittel oder Bindemittelmischung in der Reliefschicht beträgt in der Regel 40 bis 90 Gew. %, bezogen auf die Menge aller Bestandteile. Bevorzugt werden 40 bis 85 % eingesetzt und besonders bevorzugt 40 bis 80 %.

Erfindungsgemäß wird das Bindemittel in Kombination mit einem geeigneten Weichmacher eingesetzt. Es können auch Gemische verschiedener Weichmacher eingesetzt werden. Beispiele für geeignete Weichmacher sind modifizierte und unmodifizierte Naturöle und -harze, Alkyl-, Alkenyl-, Arylalkyl- oder Arylalkenylester von Säuren, wie Alkansäuren, Arylcarbonsäuren oder Phosphorsäure; synthetische Oligomere oder Harze wie Oligostyrol, oligomere Styrol-Butadien-Copolymere, oligomere α-Methylstyrol/p-Methylstyrol-Copolymere, flüssige Oligobutadiene, oder flüssige oligomere Acrylnitril-Butadien-Copolymere; sowie Polyterpene, Polyacrylate, Polyester oder Polyurethane, Polyethylen, Ethylen-Propylen-Dien-Kautschuke oder α-Methyl-Oligo(ethylenoxid). Beispiele besonders gut geeigneter Weichmacher sind paraffinische Mineralöle; Ester von Dicarbonsäuren wie Dioctyladipat oder Terephthalsäuredioctylester; naphthenische Weichmacher oder Polybutadiene mit einem Molgewicht zwischen 500 und 5000 g/mol.

Die Menge an Weichmacher in der fotopolymeren Schicht beträgt erfindungsgemäß 10 bis 40 Gew. %, bezogen auf die Menge aller Bestandteile. Bei weniger als 5 Gew. % ist die Platte im Regelfalle nicht mehr schnell genug verarbeitbar, auch wenn in Spezialfällen noch zufriedenstellende Ergebnisse erzielt werden können. Außerdem weisen diese Platten eine starke Anisotropie mit den dadurch bedingten negativen Druckeigenschaften auf. Bei mehr als 50 Gew. % Weichmacher sind die Reliefeigenschaften im Regelfalle nicht mehr für den Flexodruck geeignet. Die genaue Menge wird vom Fachmann je nach dem verwendeten Bindemittel und der gewünschten Härte der Druckplatte gewählt. Bevorzugt werden 20 bis 35 Gew. % eingesetzt.

Die fotoempfindliche Schicht enthält weiterhin in bekannter Weise polymerisierbare Verbindungen, beziehungsweise Monomere. Die Monomeren sollen mit den Bindemitteln verträglich sein und mindestens eine polymerisierbare, ethylenisch ungesättigte Doppelbindung aufweisen. Geeignete Monomere haben im Allgemeinen einen Siedepunkt von mehr als 100°C bei Atmosphärendruck und ein Molekulargewicht von bis zu 3000 g/mol, vorzugsweise bis zu 2000 g/mol. Als besonders vorteilhaft haben sich Ester oder Amide der Acrylsäure oder Methacrylsäure mit mono- oder polyfunktionellen Alkoholen, Aminen, Aminoalkoholen oder Hydroxyethern und -estern, Ester der Fumar- oder Maleinsäure oder Allylverbindungen erwiesen. Beispiele für geeignete Monomere sind Butylacrylat, 2-Ethylhexylacrylat, Laurylacrylat, 1,4-Butandioldiacrylat, 1,6-Hexandioldiacrylat, 1,6-Hexandioldimethacrylat, 1,9-Nonandioldiacrylat, Trimethylolpropantriacrylat, Dioctylfumarat, N-Dodecylmaleimid. Die Menge an Monomeren in der Reliefschicht beträgt in der Regel 4 bis 30 Gew. %, bezogen auf die Menge aller Bestandteile, bevorzugt 4 bis 20 Gew. %.

Die Reliefschicht weist weiterhin in prinzipiell bekannter Art und Weise einen Fotoinitiator oder ein Fotoinitiatorsystem auf. Beispiele für geeignete Initiatoren sind Benzoin oder Benzoinderivate, wie α-Methylbenzoin oder Benzoinether, Benzilderivate, wie Benzilketale, Acylarylphosphinoxide, Bisacylphosphinoxide, Acylarylphosphinsäureester, Mehrkernchinone oder Benzophenone. Die Menge an Fotoinitiator in der Reliefschicht beträgt in der Regel 0,1 bis 5 Gew. %, bezogen auf die Menge aller Bestandteile.

Die Reliefschicht kann optional weitere Bestandteile wie beispielsweise Inhibitoren für die thermisch initiierte Polymerisation, Farbstoffe, Pigmente, fotochrome Zusätze, Reglersysteme, Antioxidantien, weitere Bindemittel zur Feinsteuerung der Eigenschaften oder Extrusionshilfsmittel umfassen. Im Regelfalle werden aber nicht mehr als 10 Gew. % derartiger Zusätze eingesetzt.

Als weitere Bestandteile haben sich insbesondere Verbindungen bewährt, die die fotochemische Vernetzung beschleunigen. Geeignet für diesen Zweck sind beispielsweise tertiäre Amine, die H-Atome in α-Position zum Stickstoffatom aufweisen. Als Beispiele seien Dialkylaminobezoesäurealkylester wie Diethylaminobenzoesäureethylester genannt.

Bei der fotopolymerisierbaren Schicht kann es sich auch um mehrere fotopolymerisierbare Schichten übereinander handeln, die eine gleiche, annährend gleiche oder verschiedene Zusammensetzung aufweisen. Ein mehrschichtiger Aufbau hat den Vorteil, dass die Eigenschaften der Oberfläche der Druckform, wie beispielsweise Farbübertragung verändert werden können, ohne die flexotypischen Eigenschaften der Druckform wie beispielsweise Härte oder Elastizität zu beeinflussen. Oberflächeneigenschaften und Schichteigenschaften können also unabhängig voneinander verändert werden, um ein optimales Druckergebnis zu erreichen.

Die Dicke der fotopolymerisierbaren Schicht bzw. aller fotopolymerisierbaren Schichten zusammen beträgt im Regelfalle ca. 100 bis ca. 950 mm, bevorzugt 200 bis 500 mm.

Das erfindungsgemäß eingesetzte fotopolymerisierbare Flexodruckelement weist weiterhin eine lichtdurchlässige, nicht klebrige Deckschicht auf. Substratschichten sind auch als release-layer oder Deckschichten bekannt, und erleichterten das Abziehen einer eventuell vorhandenen Schutzfolie vor dem Gebrauch des Flexodruckelementes und vermeiden so eine Beschädigung der Reliefschicht. Sie erleichtern weiterhin das Auflegen und Abnehmen des fotografischen Negativs zur Bebilderung.

Substratschichten werden von einem reissfeste Filme bildenden Polymeren und den gegebenenfalls darin enthaltenen Zusatzstoffen gebildet. Je nach Art des verwendeten Polymeren kann die Substratschicht in organischen Lösungsmitteln oder in wäßrigen Lösungsmittelsmitteln löslich sein. Beispiele geeigneter, reissfester Filme bildender Polymerer sind Polyamide, voll- oder teilverseifte Polyvinylacetate oder Polyethytenoxid/Vinylacetat-Pfropfpolymerisate, Copolyamide, Polyurethane, Poly(meth)-acrylate, Polyvinylalkohol-alkancarbonsäureester eines Hydrolysegrades von 30 bis 99%, Cyclokautschuke hohen Cyclisierungsgrads, Ethylen/Propylen-Copolymerisate, Homo- und Copolymerisate des Vinylchlorids oder Ethylen/Vinylacetat-Copolymerisate. Beispiele geeigneter Substratschichten, welche Zusatzstoffe enthalten, sind aus der DE-A 28 23 300 oder der DE-B 21 23 702 bekannt. Im Allgemeinen sind die Substratschichten 0,2 bis 25 µm dick, bevorzugt beträgt die Dicke 2 bis 20 µm.

Das erfindungsgemäß eingesetzte Flexodruckelement kann optional noch durch eine Schutzfolie, beispielsweise eine Schutzfolie aus PET, vor Beschädigungen geschützt werden, die sich auf der jeweils obersten Schicht des Flexodruckelements, also im Regelfalle auf der Substratschicht, befindet. Falls das fotoempfindliche Flexodruckelement eine Schutzfolie aufweist, muss diese vor der Durchführung des erfindungsgemäßen Verfahrens abgezogen werden.

Die gesamte Dicke des erfindungsgemäß eingesetzten, fotoempfindlichen Flexodruckelementes aus Träger, Haftschicht, fotoempfindlicher Schicht und Substratschicht - ohne eine optional vorhandene Schutzfolie - beträgt 300 bis 1000 µm, bevorzugt 400 bis 1000 µm, besonders bevorzugt 400 bis 800 µm und ganz besonders bevorzugt 450 bis 750 µm.

Die Herstellung der erfindungsgemäß eingesetzten Flexodruckelemente für den Zeitungsdruck kann beispielsweise erfolgen, indem man die Bestandteile der Haftschicht, der fotopolymerisierbaren Schicht und der Substratschicht jeweils in einem geeigneten Lösungsmittel auflöst und schichtweise nacheinander auf den metallischen Träger aufträgt. Optional kann zum Schluss die Schutzfolie aufgebracht werden. Alternativ können die Schichten in umgekehrter Reihenfolge auf die Schutzfolie aufgegossen werden und zum Schluss wird der metallische Träger aufkaschiert. Ein geeignetes Verfahren ist weiterhin in der Anmeldung DE-A 100 40 929 offenbart.

Das erfindungsgemäß eingesetzte Flexodruckelement weist eine zusätzliche, digital bebilderbare Schicht auf. Diese kann sich auf der transparenten Substratschicht befinden, bevorzugt kann beim Vorhandensein digital bebilderbarer Schichten aber auf die Substratschicht verzichtet werden.

Bei der digital bebilderbaren Schicht handelt es sich bevorzugt um eine Schicht ausgewählt aus der Gruppe der IR-ablativen Schichten, Ink-Jet-Schichten und thermografischen Schichten.

IR-ablative Schichten bzw. Masken sind für die Wellenlänge des aktinischen Lichtes opak und umfassen üblicherweise ein Bindemittel sowie mindestens einen IR-Absorber wie beispielsweise Ruß. Ruß sorgt auch dafür, dass die Schicht opak ist. In die IR-ablative Schicht kann mittels eines IR-Lasers eine Maske eingeschrieben werden, d.h. die Schicht wird an den Stellen, an denen sie vom Laserstrahl getroffen wird, zersetzt und abgetragen. Durch die entstandene Maske hindurch kann bildmäßig mit aktinischem Licht bestrahlt werden. Beispiele für die Bebilderung von Flexodruckelementen mit IR-ablativen Masken sind beispielweise in EP-A 654 150 oder EP-A 1 069 475 offenbart.

Bei Ink-Jet-Schichten wird eine mit Ink-Jet-Tinten beschreibbare Schicht, beispielsweise eine Gelatine-Schicht aufgetragen. Diese ist mittels Ink-Jet-Druckem bebilderbar. Beispiele sind in EP-A 1 072 953 offenbart.

Bei thermografischen Schichten handelt es sich um Schichten, die Substanzen enthalten, die sich unter dem Einfluss von Hitze schwarz färben. Derartige Schichten umfassen beispielsweise ein Bindemittel und ein organisches Silbersalz und können mittels eines Druckers mit Thermokopf bebildert werden. Beispiele sind in EP-A 1 070 989 offenbart.

Die digital bebilderbaren Schichten können auf die fotopolymerisierbare Schicht oder die Substratschicht in prinzipiell bekannter Art und Weise aufgegossen werden.

Das Verfahren zur Herstellung von Zeitungsflexodruckformen, ausgehend von Flexodruckelementen mit digital bebilderbaren Schichten, ist dem konventionellen Verfahren sehr ähnlich.

Für das erfindungsgemäße Verfahren wird das erfindungsgemäße Flexodruckelement als Ausgangsmaterial eingesetzt. Falls das Flexodruckelement ein Schutzfolie umfasst, wird diese zunächst abgezogen. Beschrieben wird hier zunächst die konventionelle Vorgehensweise mit fotografischem Negativ.

Im Verfahrensschritt (a) wird das erfindungsgemäße Fleoxodruckelement bildmäßig mit aktinischem Licht belichtet. Als aktinisches, also chemisch "wirksames" Licht eignet sich in bekannter Art und Weise insbesondere UVA- bzw. UV/VIS-Strahlung. Die Bestrahlung kann einerseits durch eine fotografische Maske hindurch erfolgen, die auf das Flexodruckelement aufgelegt wird.

In einer besonders vorteilhaften Ausgestaltung des erfindungsgemäßen Verfahrens wird das Flexodruckelement in einem der bildmäßigen Belichtung (a) vorgelagerten Schritt an Luft vollflächig, d.h. ohne dass die fotografische Maske aufgelegt ist, mit aktinischem Licht vorbelichtet. Die Lichtmenge wird dabei so limitiert, dass die fotopolymerisierbare Schicht auch nach dem Vorbelichten noch im Entwickler löslich ist; die Schicht darf also nicht vernetzen. Eine derartige Vorbelichtung bewirkt, dass der Gehalt des Polymerisationsinhibitors Sauerstoff in der Photopolymerenschicht reduziert wird. Dadurch wird die Platte schneller belichtbar, und es kommt zu einer besseren Versockelung der Elemente. Bei Verwendung handelsüblicher Belichter mit einer Leistung von z.B. 8 kW ist im Allgemeinen eine Vorbelichtungszeit von wenigen Sekunden völlig ausreichend.

Nach dem bildmäßigen Belichten des Flexodruckelementes wird in Verfahrensschritt (b) das Flexodruckelement mit einem organischen Lösungsmittel oder organischen Lösemittelgemisch entwickelt. Dabei werden die nicht belichteten, d.h. die von der Maske abgedeckten Bereiche der Reliefschicht entfernt, während die belichteten, d.h. die vernetzten Bereiche erhalten bleiben.

In einer Ausführungsform der Erfindung wird die Substratschicht bei diesem Verfahrensschritt mit entfernt. Zu diesem Zweck wird ein Entwickler eingesetzt werden, der sowohl die fotopolymere Schicht wie die Substratschicht lösen kann. Hierfür eignen sich insbesondere die bekannten Auswaschmittel für Flexodruckplatten, die üblicherweise aus Gemischen verschiedener organischer Lösungsmittel bestehen, die auf geeignete Art und Weise zusammenwirken. Beispielsweise können Entwickler aus naphtenischen oder aromatischen Erdölfraktionen im Gemisch mit Alkoholen, beispielsweise Benzylalkohol oder Cyclohexanol, sowie ggf. weiteren Komponenten, wie beispielsweise alicyclischen Kohlenwasserstoffen, Terpen-Kohlenwasserstoffen, substituierten Benzolen, beispielsweise Diisopropylbenzol, oder Dipropylenglycoldimethylether eingesetzt werden. Geeignete Auswaschmittel sind beispielsweise in EP-A 332 070 oder EP-A 433 374 offenbart.

Der Entwicklungsschritt wird üblicherweise bei Temperaturen oberhalb 30°C durchgeführt. In einer bevorzugten Ausgestaltung der Erfindung wird der Entwicklungsschritt aufgrund der erzielbaren schnelleren Auswaschgeschwindigkeiten bei höheren Temperaturen durchgeführt. Aus Sicherheitsgründen und zur Reduktion des apparativen Aufwands beim Entwicklungsgerät sollte die Temperatur 5 bis 15°C unter dem Flammpunkt des eingesetzten Auswaschmittels liegen.

Vorteilhaft kann in einer alternativen Ausführungsform eine Substratschicht für das Flexodruckelement gewählt werden, die aus wasserlöslichen Polymeren besteht. Diese Substratschicht kann in einem der eigentlichen Entwicklung vorausgehenden Schritt vorzugsweise mit Wasser oder einem überwiegend wässrigen Lösemitteln entfernt werden. Danach wird das Element kurz zwischengetrocknet, z.B. durch Abblasen mit Luft bzw. Druckluft, und kann nun in einem organischen Lösemittel oder organischen Lösemittelgemisch entwickelt werden.

Bevorzugt werden bei der alternativen Ausführungsform keine Gemische von verschiedenen organischen Lösemitteln, sondern nur ein einziges organisches Lösemittel oder eine bestimmte Siedefraktion einer homologen Reihe verwendet. Beispielsweise können hydrierte Erölfraktionen oder alicyclische Kohlenwasserstoffe, Terpen-Kohlenwasserstoffe, substituierte Benzole oder Dipropylenglycoldimethylether eingesetzt werden. Besonders bewährt haben sich zur Ausführung des Entwicklungsschrittes hydrierte Erdölfraktionen mit einem Siedepunkt von 180 bis 280°C und einem Flammpunkt > 55°C. Derartige entaromatisierte Kohlenwasserstoffreaktionen sind beispielsweise unter dem Namen EXXSOL^{®} D erhältlich.

Die zweistufige alternative Vorgehensweise weist zwar einen Verfahrensschritt mehr auf, hat aber den Vorteil, dass die Aufarbeitung des Entwicklers deutlich vereinfacht wird. Die Entwickler werden üblicherweise vor Ort redestilliert. Bei Entwicklern aus verschiedenen organischen Lösemitteln weist das Destillat eine andere als die eigentlich gewünschte Zusammensetzung auf, und vor erneutem Gebrauch muss analysiert und mittels frischem Lösemittel wieder richtig eingestellt werden. Dies kann bei der Verwendung eines einzigen Lösemittels entfallen.

Während Standard Flexodruckplatten mit einer PET-Trägerfolie bei 60 bis 65°C getrocknet werden, kann die erfindungsgemäß entwickelte Flexodruckplatte wegen des metallischen Trägers bei einer Temperatur von 105 bis 160°C, vorzugsweise bei 120 bis 150°C getrocknet werden. Da die Trocknung der geschwindigkeitsbestimmende Schritt des Gesamtprozesses ist, lässt sich die Gesamtprozesszeit der Flexodruckplatte dadurch drastisch reduzieren. Als Trockner sollte ein Ablufttrockner verwendet werden, um die Lösemittelanreicherung im Gasraum zu unterdrücken. Die Lösemittelkonzentration im Gasraum sollte unterhalb der unteren Explosionsgrenze liegen. Beide Anforderungen lassen sich mit Trocknern, die auf Standardtemperaturen ausgelegt sind, nicht lösen.

Falls gewünscht, kann das getrocknete Flexodruckelement danach noch üblichen Nachbehandlungsschritten, wie beispielsweise einer Entklebung durch UV-C-Strahlung unterworfen werden.

Das erfindungsgemäße Verfahren kann in weitgehend üblichen Apparaturen durchgeführt werden. Je nach Art des verwendeten Entwicklers ist gegebenenfalls Ex-Schutz erforderlich. Bevorzugt wird eine Apparatur eingesetzt, in der sich alle Verfahrensschritte Entfernen der Substratschicht mit Wasser - Zwischentrocknen - Entwickeln - Trocknen - Nachbehandeln in-line durchführen lassen.

Es können Verarbeitungszeiten von unter 30 min erreicht werden.

Auch Flexodruckelemente mit Ink-jet-Masken oder thermografischen Masken können wie beschrieben vorbelichtet werden. Bei Masken mit IR-ablativer Schicht ist dies wegen der opaken Schicht naturgemäß nicht möglich.

Danach wird zunächst die Maske mittels der jeweils notwendigen Technik in die Maskenschicht eingeschrieben und wie beschrieben mittels aktinischem Licht belichtet. So kann eine vorab aufgebrachte Maske beispielsweise mit einem Laser verdampft werden, oder durch Behandlung mit einem Laser kann die Schicht für aktinisches Licht undurchlässig gemacht werden, wie z.B. in EP-A 654 150 und DE-A 33 42 579 beschrieben.

Beim Ink-Jet Verfahren wird eine für aktinisches Licht undurchlässige Tinte auf die Nichtbildbereiche aufgebracht.

Je nach dem Löslichkeitsverhalten des als Bindemittel in der digital bebilderbaren Schicht eingesetzten Bindemittels können in einem Schritt die digital bebilderbare Schicht bzw. die Reste davon entfernt und die Reliefschicht entwickelt werden. Wenn wässrig lösliche Bindemittel eingesetzt werden, kann die digital bebilderbare Schicht auch mit Wasser entfernt, das Element zwischengetrocknet und dann die Reliefschicht mit einem organischen Lösemittel entwickelt werden. Mit anderen Worten gesagt, tritt die digital bebilderbare Schicht bei der Aufarbeitung an die Stelle der Substratschicht.

Die durch das erfindungsgemäße Verfahren erhaltene Flexodruckform auf Metallträger weist eine Reliefschicht auf, die im Regelfalle eine Shore A-Härte zwischen 50 und 80 aufweist. Drucktests zeigen, dass auch kleine Reliefelemente noch mit sehr guter Qualität auf Zeitungspapier wiedergegeben werden.

Die erhaltenen Flexodruckformen weisen darüber hinaus den Vorteil auf, dass deutlich höhere Auflagen als beim Druck mit wasserauswaschbaren Flexodruckformen möglich sind. Die Reliefschichten zeigen beim Drucken mit Druckfarben auf Wasser- oder Wasser-Alkoholbasis nur eine niedrige Quellung, so dass auch bei hohen Auflagen ein Druck mit konstanter Qualität, ohne übermäßige Tonwertzunahme möglich ist. Die Wasserfarben schlagen in Zeitungspapier sehr schnell weg. Es kann dünneres Papier, beispielsweise solches mit 42 g/m² eingesetzt werden, als beim Offset-Druck mit Offset-Druckfarben eingesetzt werden (üblicherweise mindestens 45 g/m²).

Die folgenden Beispiele sollen die Erfindung näher erläutern:

### Beispiel 1:

### Herstellung des lichtempfindlichen Flexodruckelementes

Es wurde ein flexibler, metallischer Träger aus Stahl mit einer Dicke von 170 µm eingesetzt. Der Träger wurde mit zwei Haftschichten wie in EP-A 53 260 beschrieben versehen, wobei der Oberlack einen UV-Absorber enthält.

Zur Herstellung der transparenten Substratschicht wurde Joncryl 586 (Styrol-Acrylat-Copolymer, Fa. Johnson Wax) in Benzylalkohol gelöst und auf eine PET-Folie aufgebracht. Anschließend wird eine Mischung aus Joncryl 586 und Macromelt^{®} 6900 (Polyamid, Fa. Henkel), gelöst in einer basischen Lösung aus Toluol und Alkoholen, aufgetragen.

Zur Herstellung der organisch entwickelbaren, fotopolymerisierbaren Schicht wurden die in Tabelle 1 aufgeführten Komponenten eingesetzt. Die Komponenten wurden in Toluol unter intensivem Mischen gelöst und die erhaltene Lösung auf die mit dem Substrat beschichtete PET-Schutzfolie (Dicke 125 µm) gegossen und das Lösemittel entfernt.

**Tabelle 1: Komponenten für die fotopolymerisierbare Schicht**

| Komponente | Typ | Menge (Gew.-%) |
|---|---|---|
| SBS-Blockcopolymer | Kraton D-1102, 29,5 Gew.-% Styrol, 72° Shore A Härte, MW = 125.000 g/mol | 67 |
| Weichmacher | Polyöl 130 (Polybutadienöl) | 20 |
| Monomer | 1,6 Hexandioldiacrylat | 10 |
| Fotoinitiator | Benzildimethylketal | 2 |
| Zusatzstoffe | | 1 |
| Summe | | 100 |

Die erhaltene fotopolymere Schicht wurde in einem weiteren Schritt mit der von der PET-Folie abgewandten Seite auf den auf die mit der Haftschicht beschichtete Seite des Trägers aufkaschiert. Die PET-Folie fungiert nun als Schutzfolie für das Flexodruckelement.

Das erhaltene fotoempfindliche Flexodruckelement hat eine Dicke von 675 µm. Davon entfallen 125 µm auf die Schutzfolie, 10 µm auf die Substratschicht, 350 µm auf die fotopolymerisierbare Reliefschicht und 190 µm auf das Trägerblech mit Haftlack.

### Beispiel 2:

Es wurde wie in Beispiel 1 vorgegangen, nur wurden 5 Gew. % eines sekundären Bindemittels eingesetzt. Die Einsatzstoffe sind in Tabelle 2 aufgeführt.

**Tabelle 2: Komponenten für die fotopolymerisierbaren Schicht**

| Komponente | Typ | Menge (Gew.-%) |
|---|---|---|
| SBS-Blockcopolymer | Kraton D-1102, 29,5 Gew.-% Polystyrol, 72° Shore A Härte, MW = 125.000 g/mol | 62 |
| SIS-Blockcopolymer | Kraton D-1161 NU, 15 Gew.-% Polystyrol, 31° Shore A Härte, MW = 210.000 g/mol | 5 |
| Weichmacher | Polyöl 130 | 20 |
| Monomer | 1,6 Hexandioldiacrylat | 10 |
| Fotoinitiator | Benzildimethylketal | 2 |
| Zusatzstoffe | | 1 |
| Summe | | 100 |
| | Verhältnis SBS/SIS | 92,5/7,5 |

### Vergleichsbeispiel 1:

Es wurde wie in Beispiel 1 vorgegangen, nur wurde ein Bindemittel (Kraton DX-1000) mit einem M_{w} von 230000 g/mol eingesetzt.

### Vergleichsbeispiel 2:

Es wurde wie in Beispiel 1 vorgegangen, nur wurde der Anteil des Weichmachers auf unter 5 Prozent gesenkt. Die Anteile der anderen Komponenten erhöhten sich entsprechend.

### Vergleichsbeispiel 3:

Es wurde wie in Beispiel 1 vorgegangen, nur wurde ein Styrol-Butadien-Styrol-Blockcopolymers mit einem Styrolgehalt von 73 % eingesetzt (Atofina, Finaclear 520, Shore A Härte > 90°). Es wurde nur eine trübe fotopolymerisierbare Schicht erhalten. Die Shore A Härte der Schicht betrug 98.

### Beispiel 3:

### Herstellung der Flexodruckplatte

Von dem gemäß Beispiel 1 hergestellten fotoempfindlichen Flexodruckelement wurde die PET-Schutzfolie abgezogen. Die transparente Substartschicht verblieb auf der fotoempfindlichen Schicht. Die Platte wurde für 3 s mit UV-Licht von der Vorderseite vorbelichtet. Anschließend wurde ein fotografisches Negativ aufgelegt und die fotoempfindliche Schicht durch das Negativ hindurch für 2.5 min mit UV-VIS-Licht bildmäßig belichtet.

Die Substratschicht und die unbelichteten Teile der Reliefschicht wurden mit einem Auswaschmittel aus Exxsol D60 (40%), Decalin (40%) und Pentanol (20%) bei 30°C innerhalb von 4.5 min ausgewaschen. Anschließend wurde die erhaltene Druckplatte bei 130°C getrocknet. Die Platte war nach 5 min vollständig trocken.

Durch anschließende jeweils 5 minütige UVA- und UVC-Nachbelichtung wurde die Druckplatte vollständig vernetzt und entklebt.

Die Gesamtzeit zur Herstellung der Platte betrug 23 min.

Mit der erhaltenen Flexodruckplatte wurden Druckversuche (W + H Olympia) auf rauem Zeitungspapier durchgeführt. Der Druck war in Bezug auf Kontrast, Farbübertragung und Tonwertzunahme sehr gut.

### Vergleichsbeispiel 4:

Es wurde ein handelsübliches fotoempfindliches Flexodruckelement auf PET-Folie mit einer Härte von 33° Shore A (nyloflex FAC-X der BASF Drucksysteme GmbH) eingesetzt, welches zur Verwendung mit rauen Bedruckstoffen empfohlen ist, und gemäß der empfohlenen Standard-Prozedur (Arbeitsanleitung Flexodruckplatten, BASF Drucksysteme GmbH) zu einer Flexodruckplatte verarbeitet. Es wurde bei 65°C getrocknet. Die Trockenzeit betrug 2 h. Die Gesamtzeit zur Herstellung der Platte betrug mehr als 3 Stunden.

Anschließend wurden Druckversuche mit der erhaltenen Flexodruckplatte wie in Beispiel 3 beschrieben durchgeführt. Das Druckbild wies starke Quetschränder und vollgelaufene Typen im Druck auf.

### Vergleichsbeispiel 5:

Es wurde wie in Beispiel 3 vorgegangen, nur wurde die erhaltene Platte bei einer Temperatur von 65°C getrocknet. Die Gesamtzeit zur Herstellung der Platte betrug mehr als 2 h.

### Vergleichsbeispiel 6:

Es wurde wie in Beispiel 3 vorgegangen, nur wurde das in Vergleichsbeispiel 1 beschriebene Flexodruckelement zur Herstellung der Druckform eingesetzt.

Sowohl die Auswaschzeit als auch die Trockenzeit verlängerten sich. Die Gesamtzeit zur Herstellung der Platte betrug mehr als 30 min.

### Vergleichsbeispiel 7:

Es wurde wie in Beispiel 3 vorgegangen, nur wurde das in Vergleichsbeispiel 2 beschriebene Flexodruckelement zur Herstellung der Druckform eingesetzt. A

### (Aufgrund der zu geringen Zwischentiefen am Klischee wurde beim Druckversuch ein unsauberes Druckbild erhalten.

### Vergleichsbeispiel 8:

Es wurde wie in Beispiel 3 vorgegangen, nur wurde das in Vergleichsbeispiel 3 beschriebene Flexodruckelement zur Herstellung der Druckform eingesetzt.

Die trübe fotopolymerisierbare Schicht vernetzte aufgrund zu starker Streuung beim bildmäßigen Belichten vollständig und war nicht mehr zum Drucken geeignet.

## Patentansprüche

1. Verfahren zum Herstellen von Flexodruckplatten für den Zeitungsdruck, wobei man als Ausgangsmaterial ein fotoempfindliches Flexodruckelement einsetzt, umfassend - übereinander angebracht - mindestens
• einen flexiblen, metallischen Träger,
• eine darauf aufgebrachte Haftschicht,
• eine organisch entwickelbare fotopolymerisierbare Schicht, welche ihrerseits mindestens 40 bis 80 Gew.-% eines thermoplastisch elastomeren Bindemittels vom SBS-Typ, das auch ganz oder teilweise hydriert sein kann, 4 bis 20 Gew.-% ethylenisch ungesättigte Monomere, 0,1 bis 5 Gew.-% eines Fotoinitiators oder eines Fotoinitiatorsystems sowie mindestens einen Weichmacher umfasst, wobei die Mengen jeweils auf die Menge aller Bestandteile der fotopolymerisierbaren Schicht bezogen sind,
• eine digital bebilderbare Schicht, sowie
• optional eine abziehbare Schutzfolie
wobei die Gesamtdicke des Flexodruckelementes 300 bis 1000 µm beträgt, das elastomere Bindemittel ein Gewichtsmittel M_{w} von 80 000 bis 150 000 g/mol, einen Styrol-Gehalt von 20 bis 50 Gew.-% bezüglich des Bindemittels und eine Härte Shore A von 50 bis 80 aufweist, und die Menge an Weichmacher 10 bis 40 Gew. %, bezogen auf die Menge aller Bestandteile der fotopolymerisierbaren Schicht, beträgt,
wobei das Verfahren mindestens die folgenden Schritte umfasst:
(a) Einschreiben einer Maske in die digital bebilderbare Schicht,
(b) Belichten des Flexodruckelementes mit aktinischem Licht durch die gebildete Maske hindurch,
(c) Entfernen der digital bebilderbaren Schicht bzw. der Reste davon und Entwickeln der belichteten Schicht mit einem organischen Lösemittel oder einem organischen Lösemittelgemisch,
(d) Trocknen der Schicht,
wobei der Trockenschritt (d) bei einer Temperatur von 105 bis 160 °C durchgeführt wird.

2. Verfahren nach Anspruch 1, **dadurch gekennzeichnet, dass** das Blockcopolymere einen Styrolgehalt von 25 bis 45 Gew.-% aufweist.

3. Verfahren nach Anspruch 2, **dadurch gekennzeichnet, dass** die fotopolymerisierbare Schicht zusätzlich 0-10 Gew. % mindestens eines sekundären Bindemittels umfasst.

4. Verfahren gemäß einem der Ansprüche 1 bis 3, **dadurch gekennzeichnet, dass** es sich bei der digital bebilderbaren Schicht um eine Schicht ausgewählt aus der Gruppe der IR-ablativen Schichten, Ink-Jet-Schichten und thermografischen Schichten handelt.

5. Verfahren gemäß einem der Ansprüche 1 bis 4, **dadurch gekennzeichnet, dass** die digital bebilderbare Schicht ein wässrig lösliches Bindemittel umfasst.

6. Verfahren nach einem der Ansprüche 1 bis 5, **dadurch gekennzeichnet, dass** der Trockenschritt (d) bei 120 bis 150 °C durchgeführt wird.

7. Verfahren nach einem der Ansprüche 1 bis 6, **dadurch gekennzeichnet, dass** der Entwicklungsschritt (b) bei einer Temperatur von 5 bis 15 °C unter dem Flammpunkt des Lösemittels oder Lösemittelgemisches ausgeführt wird.

8. Verfahren nach einem der Ansprüche 1 bis 7, **dadurch gekennzeichnet, dass** man das Flexodruckelement eine digital bebilderbare Schicht mit einem wässrig löslichen Bindemittel aufweist, und man die digital bebilderte Schicht zunächst mit Wasser oder einem überwiegend wässrigen Lösemittelgemisch entfernt, das Element zwischentrocknet und danach die belichtete Schicht mit einem organischen Lösemittel oder einem organischen Lösemittelgemisch entwickelt.

9. Verfahren nach Anspruch 8, **dadurch gekennzeichnet, dass** man den Entwicklungsschritt mit einer hydrierten Erdölfraktion mit einem Siedebereich von 180 bis 280 °C und einem Flammpunkt > 55 °C durchführt.

## Claims

1. A process for the production of flexographic printing plates for newspaper printing where the starting material employed is a photosensitive flexographic printing element, comprising - applied one on top of the other - at least
- a flexible, metallic support,
- an adhesive layer applied thereto,
- a photopolymerizable layer which can be developed in organic media and which itself comprises at least from 40 to 80% by weight of a thermoplastic elastomeric binder of the SBS type, which can also be fully or partially hydrogenated, from 4 to 20% by weight of ethylenically unsaturated monomers, from 0.1 to 5% by weight of a photoinitiator or photoinitiator system and at least one plasticizer, wherein the amounts are each based on the amount of all constituents of the photopolymerizable layer,
- a digitally imageable layer, and
- optionally a removable protective film,
wherein the total thickness of the flexographic printing element is from 300 to 1000 µm, the elastomeric binder has a weight average molecular weight M_{w} of from 80,000 to 150,000 g/mol, a styrene content of from 20 to 50% by weight based styrene content of from 20 to 50% by weight based on the binder and a Shore A hardness of from 50 to 80, and the amount of plasticizer is from 10 to 40% by weight, based on the amount of all constituents of the photopolymerizable layer,
wherein the process comprises at least the following steps:
(a) writing a mask into the digitally imageable layer,
(b) exposure of the flexographic printing element to actinic light through the mask formed,
(c) removal of the digitally imageable layer or the remnants thereof and development of the exposed layer using an organic solvent or an organic solvent mixture,
(d) drying of the layer,
wherein the drying step (d) is carried out at a temperature of from 105 to 160°C.

2. The process according to claim 1, wherein the block copolymer has a styrene content of from 25 to 45% by weight.

3. The process according to claim 2, wherein the photopolymerizable layer additionally comprises 0-10% by weight of at least one secondary binder.

4. The process according to any one of claims 1 to 3, wherein the digitally imageable layer comprises a layer selected from the group consisting of IR-ablative layers, ink-jet layers and thermographic layers.

5. The process according to any one of claims 1 to 4, wherein the digitally imageable layer comprises a binder that is soluble in an aqueous medium.

6. The process according to any one of claims 1 to 5, wherein the drying step (d) is carried out at from 120 to 150°C.

7. The process according to any one of claims 1 to 6, wherein the development step (b) is carried out at a temperature of from 5 to 15°C below the flash point of the solvent or solvent mixture.

8. The process according to any one of claims 1 to 7, wherein the flexographic printing element comprises a digitally imageable layer comprising a binder that is soluble in an aqueous medium, and the digitally imageable layer is firstly removed using water or a substantially aqueous solvent mixture, the element is subjected to interim drying, and the exposed layer is then developed using an organic solvent or an organic solvent mixture.

9. The process according to claim 8, wherein the development step is carried out using a hydrogenated petroleum fraction having a boiling range of from 180 to 280°C and a flash point of > 55°C.

## Revendications

1. Procédé pour la fabrication de plaques d'impression flexographique pour les journaux, dans le cadre duquel on utilise comme matière première un élément d'impression flexographique photosensible, comportant, de manière superposée, au moins
- un support métallique flexible,
- une couche d'adhérence appliquée sur ce dernier,
- une couche photopolymérisable pouvant être développée de manière organique qui, pour sa part, comporte au moins 40 à 80 % en poids de liant élastomère de type SBS thermoplastique, pouvant être, lui aussi, totalement ou partiellement hydrogéné, 4 à 20 % en poids de monomères éthyléniques insaturés, 0,1 à 5 % en poids d'un photoinitiateur ou d'un système photoinitiateur, ainsi qu'au moins un plastifiant, les quantités respectives étant définies par rapport à la quantité totale des composants de la couche photopolymérisable,
- une couche que l'on peut graver numériquement, ainsi
- qu'en option une feuille de protection amovible,
l'épaisseur totale de l'élément d'impression flexographique étant comprise entre 300 et 1000 µm, le liant élastomère présentant une masse moléculaire moyenne M_{w} allant de 80 000 à 150 000 g/mol, une teneur en styrène allant de 20 à 50 % en poids par rapport au liant et une dureté Shore A allant de 50 à 80, et la quantité de plastifiant étant de 10 à 40 % en poids par rapport à la masse de tous les composants de la couche photopolymérisable,
le procédé comportant au moins les étapes suivantes :
(a) création d'un masque dans la couche qui peut être gravée numériquement,
(b) exposition de l'élément d'impression flexographique à la lumière actinique traversant le masque formé
(c) enlèvement de la couche gravée numériquement et/ou de ses résidus, et développement de la couche exposée à l'aide d'un solvant organique ou d'un mélange de solvants organiques,
(d) séchage de la couche,
l'étape de séchage (d) étant effectuée à une température allant de 105 à 160 °C.

2. Procédé selon la revendication 1, **caractérisé en ce que** les copolymères séquencés présentent une teneur en styrène allant de 25 à 45 % en poids.

3. Procédé selon la revendication 2, **caractérisé en ce que** la couche photopolymérisable comporte au moins 0-10 % en poids au moins d'un deuxième liant secondaire.

4. Procédé selon l'une quelconque des revendications 1 à 3, **caractérisé en ce que** la couche à graver numériquement est une couche choisie parmi le groupe des couches ablatives par IR, des couches « jet d'encre » et des couches thermographiques.

5. Procédé selon l'une quelconque des revendications 1 à 4, **caractérisé en ce que** la couche à graver numériquement comporte un liant soluble dans l'eau.

6. Procédé selon l'une quelconque des revendications 1 à 5, **caractérisé en ce que** l'étape de séchage (d) est réalisée à une température comprise entre 120 et 150 °C.

7. Procédé selon l'une quelconque des revendications 1 à 6, **caractérisé en ce que** l'étape de développement (b) est réalisée à une température comprise entre 5 et 15 °C en-dessous du point d'inflammation du solvant ou du mélange de solvants.

8. Procédé selon l'une quelconque des revendications 1 à 7, **caractérisé en ce que** l'élément d'impression flexographique présente une couche à graver numériquement avec un liant soluble dans l'eau, **en ce que** la couche à graver numériquement est enlevée d'abord avec de l'eau ou avec un mélange de solvants essentiellement aqueux, et **en ce que** l'élément est séché dans l'intervalle, et qu'ensuite la couche exposée est développée avec un solvant organique ou un mélange de solvants organiques.

9. Procédé selon la revendication 8, **caractérisé en ce que** l'étape de développement est réalisée avec une fraction de pétrole hydrogénée présentant un domaine d'ébullition allant de 180 à 280 °C et un point d'inflammation > 55 °C.
